# EUROPÄISCHE PATENTSCHRIFT

(11) **EP 1 478 026 B1**
(45) Veröffentlichungstag und Bekanntmachung des Hinweises auf die Patenterteilung: **27.07.2011**
(21) Anmeldenummer: 04090197.7
(22) Anmeldetag: 17.05.2004
(51) Int. Cl.: H01L 51/52

(54) **Photolumineszenzanzeigeelement und Display auf Basis von Photolumineszenzanzeigeelementen**
Photoluminescent display element and display based on photoluminescent elements
Element photoluminescent et dispositif d'affichage à base des élements photoluminescents

(30) Priorität: 15.05.2003 EP 03090139
(43) Veröffentlichungstag der Anmeldung: 17.11.2004
(73) Patentinhaber: Samsung Mobile Display Co., Ltd., Suwon-si Gyeonggi-do (KR)
(72) Erfinder: Redecker, Michael Dr., 12305 Berlin (DE); Fischer, Joerg, 13053 Berlin (DE)
(74) Vertreter: Hengelhaupt, Jürgen

(56) Entgegenhaltungen:
- WO-A-01/24290
- WO-A-03/022008
- US-A- 5 294 810
- US-A1- 2002 027 537
- US-A1- 2002 055 015
- OHMORI Y ET AL: "Multi-color emission organic EL diode with vapor deposited multi-layer structure" LASERS AND ELECTRO-OPTICS SOCIETY ANNUAL MEETING, 1996. LEOS 96., IEEE BOSTON, MA, USA 18-19 NOV. 1996, NEW YORK, NY, USA,IEEE, US, 18. November 1996 (1996-11-18), Seiten 84-85, XP010205075 ISBN: 0-7803-3160-5
- YOUNG RALPH H ET AL: "Current-induced fluorescence quenching in organic light-emitting diodes" APPLIED PHYSICS LETTERS, AIP, AMERICAN INSTITUTE OF PHYSICS, MELVILLE, NY, US, Bd. 80, Nr. 5, 4. Februar 2002 (2002-02-04), Seiten 874-876, XP012031481 ISSN: 0003-6951

## Beschreibung

Die Erfindung betrifft ein Photolumineszenzanzeigeelement (PQD), welches in einem emissiven Modus zur Umwandlung von Signalspannungen in Licht und/oder in einem reemissiven Modus zur Unterdrückung einer Photolumineszenzemission schaltbar ist und ein Display auf Basis von Photolumineszenzanzeigeelementen (PQD) sowie ein Verfahren zur Umwandlung von Signalspannungen in optische Bildinformationen.

Flachdisplays auf der Basis organischer Leuchtdioden (OLEDs) zeichnen sich durch hohe Brillianz und weiten Betrachtungswinkel aus. Als selbstemissive Technologie benötigen OLED-Displays keine Hintergrundbeleuchtung und können damit unter Bedingungen mit niedrigem bis mittlerem Umgebungslichtanteil energetisch vorteilhaft eingesetzt werden.

Unter Bedingungen mit einem hohen Anteil an Umgebungslicht, z.B. in direktem Sonnenlicht, muß jedoch überproportional viel Leistung aufgewendet werden, um die benötigte Helligkeit zu erreichen. Zudem sind die benötigten Ströme für die Ansteuerung der emissiven Bauelemente entsprechend hoch. Daher sind bei einem hohen Umgebungslichtanteil reflektive und reemissive Technologien, wie zum Beispiel Flüssigkristallanzeigen, überlegen. Deren Nachteil besteht jedoch darin, daß sie für die Operation unter Bedingungen mit wenig Umgebungslicht eine Hintergrundbeleuchtung (Backlight) benötigen, durch welche sich die baulichen Ausmaße und die Energieaufnahme bei geringem Umgebungslichtanteil überproportional erhöhen. Bauelemente, die auf der Basis organischer Leuchtdioden sowohl im emissiven als auch im reemissiven Modus betrieben werden können, sind aus DE 100 42 974 A1 bekannt. Ein solches Photolumineszenzanzeigeelement (PQD, Photoluminescence Quenching Device) hat die Struktur ähnlich einer organischen Leuchtdiode und kann im selbstemissiven Modus, d.h. ohne Umgebungslicht, aber auch im reemissiven Modus betrieben werden. Im reemissiven Modus wird die Intensität des Photolumineszenzlichts durch das Anlegen einer Spannung in Sperrichtung des PQD gesteuert. Bei entsprechender Wahl der Kontakt- und Emittermaterialien läßt sich mit den oben beschriebenen Bauelementen der Betrieb sowohl im emissiven als auch im reemissiven (Photolumineszenzlöschungs-) Modus, der so genannte duale Betrieb, realisieren. Vorteilhafterweise wird hierfür kein Backlight benötigt. Voraussetzung für den reemissiven Betrieb ist, dass ausreichend Umgebungslicht absorbiert werden kann. Außerdem ist es erforderlich, sowohl negative als auch positive Steuerspannungen für das Anzeigeelement bereitzustellen.

In der Grundstruktur bestehen Photolumineszenzanzeigeelemente aus einem transparenten, leitfähigen Kontakt, einer Emitterschicht und einem Gegenkontakt. Zur Steuerung der Helligkeit des Anzeigeelementes wird der Metallkontakt positiv gegenüber dem transparenten Kontakt gepolt, was dem Betrieb in Sperrrichtung (reemissiver Betrieb) entspricht. Diese Struktur weist jedoch im reemissiven Betrieb eine Begrenzung hinsichtlich der Leistungsfähigkeit auf, da auch in Sperrrichtung die Injektionsbarrieren endlich sind und infolgedessen merkliche Dunkelströme fließen. Diese Dunkelströme verschlechtern die Energiebilanz, insbesondere bei niedriger Helligkeit des Anzeigeelementes. Zudem müssen für den Metallkontakt unedle Metalle wie Aluminium oder Kalzium eingesetzt werden, welche eine aufwendige Verkapselung zum Schutz vor Korrosion erfordern. Zur Verbesserung der Energiebilanz von Leuchtdioden offenbart WO 03/022008 A eine OLED zur Verwendung in einem Display, bestehend aus einem Substrat, Elektroden, einer lichtemittierenden Schicht und zwischen den Elektroden und der lichtemittierenden Schicht angeordnete Löcher- und/oder Elektronenblockierschichten, wobei das höchste besetzte Molekülorbital (HOMO) der Löcherblockierschicht unterhalb des HOMO der lichtemittierenden Schicht und das niedrigste unbesetzte Molekülorbital (LUMO) der Elektronenblockierschicht oberhalb des LUMO der lichtemittierenden Schicht liegen soll. Dabei erfüllt die Elektronenblockierschicht in WO 03/022008 A die Aufgabe, ein Wandern von Elektronen (im emissiven Modus, d.h. während der Elektrolumineszenz) von der (Metall-)Kathode zur Anode (und damit einen Effizienzverlust wg. nicht-Rekombination des Elektrons) zu verhindern.

Zur Verbesserung der Energiebilanz von Leuchtdioden sind weiterhin aus US 5,294,810 und US 6,097,147 Mehrschichtstrukturen bekannt. Diese Strukturen sind auf eine optimale Funktionalität im emissiven Betrieb der Leuchtdiode optimiert, das heißt für eine optimale Injektion von Ladungsträgern. Ebenso sind nach dem Stand der Technik die Anwendung von anorganischen Materialien in organischen Leuchtdioden als Mittel zur Verbesserung der Injektion von Elektronen und Löchern für den emissiven Betrieb bekannt.

Darüber hinaus ist die Anwendung von Fluoriden und Oxiden von Alkali- und Erdalkalimetallen zur Verbesserung der Elektroneninjektion in EP 1 083 612 beschrieben.

Sämtliche nach dem Stand der Technik bekannten Mehrschichtsysteme für organische Leuchtdioden realisieren jedoch lediglich eine günstige Injektion von Elektronen im emissiven Betrieb der organischen Leuchtdiode. Es ist insoweit mit den bekannten Vorrichtungen nicht möglich, eine Reduzierung der Elektroneninjektion für den reemissiven Betrieb einer organischen Leuchtdiode zu erzielen. Ein weiterer Nachteil der bekannten Vorrichtungen nach dem Stand der Technik besteht darin, dass für den (Metall-)Kontakt eines OLED-Displays für den reemissiven Betrieb (welcher im reemissiven Betrieb die Anode ausbildet) stets unedle Metalle, wie Al oder Ca verwendet werden müssen, was zu einem erheblichen Verkapselungsaufwand bzw. zu einer niedrigen Lebensdauer des Displays führt.

Im reemissiven Betrieb ist die Verwendung unedler Metalle als Anode nötig, um eine grosse Barriere für die hier unerwünschte Injektion von Löchern zu erzeugen. Dies ist möglich durch die Wahl von Kontaktmaterialien mit niedriger Elektronenaustrittsarbeit.

Es ist daher Aufgabe der vorliegenden Erfindung, ein Photolumineszenzanzeigeelement (PQD), welches in einem reemissiven Modus schaltbar ist, und ein Display auf Basis von Photolumineszenzanzeigeelementen (PQD) anzugeben, welche bei einem reemissiven Betrieb einen sehr geringen Dunkelstrom aufweisen. Hierdurch soll insbesondere die Leistungsfähigkeit des Displays bzw. des PQD bei niedriger Helligkeit erhöht werden. Darüber hinaus soll ein PQD/Display für den reemissiven Betrieb angegeben werden, welches bei vorgegebenen Anforderungen an die Lebensdauer einen geringeren Verkapselungsaufwand als die bekannten PQDs/Displays aufweist.

Diese Aufgabe wird erfindungsgemäß gelöst durch die Merkmale im kennzeichnenden Teil des Anspruchs 1 im Zusammenwirken mit den jeweiligen Merkmalen im Oberbegriff. Zweckmäßige Ausgestaltungen der Erfindung sind in den Unteransprüchen enthalten.
Ein besonderer Vorteil der Erfindung besteht in der Reduzierung des Dunkelstroms für Photolumineszenzanzeigeelemente und Displays auf Basis von Photolumineszenzanzeigeelementen im reemissiven Betrieb.

Dazu umfasst ein Photolumineszenzanzeigeelement (PQD), eine erste Elektrode, welche lichtdurchlässig und auf der Frontseite eines organischen Materials angeordnet ist, organisches, lichtemittierendes Material, und eine zweite Elektrode, welche auf der Rückseite des organischen Materials angeordnet ist, wobei das Photolumineszenzanzeigeelement eine Löcherblockierschicht aufweist, welche zwischen dem organischen Material und der ersten Elektrodenschicht angeordnet ist und das höchste besetzte Molekülorbital der Löcherblockierschicht energetisch niedriger als das höchste besetzte Molekülorbital des organischen Materials ist und die Löcherblockierschicht Zirkonoxid, Hafniumoxid, Zinksulfid, Zinnoxid, Titanoxid, Tantaloxid und/oder Zinkoxid und die zweite Elektrodenschicht Gold, Palladium, Platin, transparent leitfähige Oxide wie Indium-Zinnoxid oder Indium-Zinkoxid und/oder Nickel umfasst. Durch diese Ausgestaltung wird eine invertierte Schichtstruktur erzeugt, welche im reemissiven Betrieb, d.h. im Photolumineszenzunterdrückungsmodus arbeitet.

Dabei dient der transparente Kontakt (erste Elektrodenschicht) zur Extraktion von Elektronen und wird positiv gegenüber dem Metallkontakt (zweite Elektrodenschicht) gepolt, ohne dass eine Ladungsträgerinjektion stattfindet. Grundsätzlich wäre zu erwarten, dass mit einer solchen Schichtstruktur aufgrund der Injektion von Ladungsträgern kein reemissiver Betrieb möglich ist. Er wurde jedoch gefunden, dass durch geeignete Wahl des Metallkontaktes sichergestellt werden kann, dass allein durch die hohe Austrittsarbeit des Metalls keine Injektion von Elektronen stattfindet. Die Injektion von Löchern aus dem transparenten Kontakt wird durch die Löchersperrschicht verhindert. Dazu muss die Energielage des Valenzbandes der Sperrschicht möglichst niedrig liegen. Dies wird durch die Wahl anorganischer Halbleiter mit grosser Bandlücke wie SnO₂, TiO₂, ZnO, ZrO₂, Ta₂O₅, HfO₂ und ZnS erreicht. Dadurch kann einerseits der unerwünschte Dunkelstrom im reemissiven Betrieb unterdrückt; andererseits die Korrosionsbeständigkeit des Displays (durch die Möglichkeit der Verwendung von Gold, Palladium, Platin, transparent leitfähigen Oxiden wie Indium-Zinnoxid oder Indium-Zinkoxid und/oder Nickel für die Kathode deutlich erhöht werden.

Durch die erfindungsgemäße Ausgestaltung der Energieniveaus der Molekülorbitale der Löcherblockierschicht können Barrieren für die unerwünschte Injektion von Ladungsträgern in Rückwärtsrichtung beim reemissiven Betrieb des Displays geschaffen werden.

Überraschender Weise hat sich gezeigt, dass ein Display, bei welchem das höchste besetzte Molekülorbital der Löcherblockierschicht energetisch niedriger als das höchste besetzte Molekülorbital der Emitterschicht ist, besonders vorteilhaft für den reemissiven Betrieb, d.h. zur Unterdrückung einer Photolumineszenzemission verwendet werden kann, da durch die erfindungsgemäße Ausgestaltung des Displays der (unerwünschte) Dunkelstrom (in Rückwärtsrichtung) erheblich verringert bzw. unterdrückt werden kann.

Durch die erfindungsgemäße Ausgestaltung der Energieniveaus der Molekülorbitale der Löcherblockierschicht können Barrieren für die unerwünschte Injektion von Ladungsträgern in Rückwärtsrichtung beim reemissiven Betrieb des Displays geschaffen werden.

Weiterhin ist eine gute energetische Anpassung des Leitungsbandes bzw. LUMO (niedrigstes unbesetztes Molekülorbital) der Löcherblockierschicht an das LUMO der Emitterschicht sowie die Anpassung des Valenzbandes bzw. des höchsten besetzten Molekülorbitals (HOMO) der Elektronenblockierschicht an das HOMO der Emitterschicht von Vorteil, so dass in der Emitterschicht während des reemissiven Betriebs erzeugte Ladungsträger ohne Barrieren abfließen können.

In einer bevorzugten Ausführungsvariante entspricht das niedrigste unbesetzte Molekülorbital der Emitterschicht dem niedrigsten unbesetzten Molekülorbital der Löcherblockierschicht und das höchste besetzte Molekülorbital der Elektronenblockierschicht entspricht dem höchsten besetzten Molekülorbital der Emitterschicht. Sind die Energien des Leitungsbandes der Emitterschicht und der Löcherblockierschicht und die Energien des Valenzbandes der Emitterschicht und der Elektronenblockierschicht gleich, ist sowohl emissiver als auch reemissiver Betrieb möglich.

Ein weiterer Vorteil der Erfindung besteht darin, dass ein erfindungsgemäßes Photolumineszenzanzeigeelement bei vorgegebenen Anforderungen an die Lebensdauer einen geringeren Verkapselungsaufwand aufweist, was zu einem erheblichen Kostenvorteil bzw. zu einer längeren Lebensdauer führt. Dazu wird eine Anpassung der Energieniveaus der Löcherblockierschicht, der Emitterschicht und der Elektronenblockierschicht derart durchgeführt, dass die Ladungsträger beim Abfließen (im reemissiven Betrieb) zwar keine Barriere überwinden müssen, jedoch umgekehrt beim Vorwärtsbetrieb (emissiver Betrieb) Barrieren für die Injektion bestehen. Hierdurch ist zwar lediglich der reemissive Betrieb möglich, jedoch läßt sich die Anode vorteilhafterweise aus edlen, korrosionsbeständigeren Metallen, wie z.B. Silber, Gold, Palladium, Platin und/oder Nickel ausbilden, was zu einer höheren Lebensdauer führt.

Grundsätzlich darf die Austrittsarbeit des Kontaktmaterials jedoch nur so weit erhöht werden, dass noch keine Lochinjektion in das Valenzband der Löcherblockierschicht möglich ist.

Es wurde jedoch gefunden, dass die Ausbildung der Löcherblockierschicht aus Zinnoxid, Hafniumoxid, Zirkonoxid, Titanoxid, Tantaloxid, Zinksulfid und/oder Zinkoxid dazu führt, dass als Anode Gold, Palladium, Platin, transparent leitfähige Oxide wie Indium-Zinnoxid oder Indium-Zinkoxid und/oder Nickel (mit höherer Lebensdauer) verwendet werden können, weil bei diesen Halbleitern die Energie des Valenzbandes ausreicht, um die Injektion von Löchern selbst aus den genannten Edelmetall-Kontaktmaterialien zu verhindern.

Erst durch diese Kombination wird ein Photolumineszenzanzeigeelement für den reemissiven Betrieb mit höherer Lebensdauer bzw. einem niedrigeren Verkapselungsaufwand möglich.

Durch diese Freiheit der Materialwahl (nicht auf unedle Metalle begrenzt, so dass auch Materialien mit verbesserter Korrosionsbeständigkeit verwendet werden können) können ebenfalls invertierte Schichtstrukturen hergestellt werden, bei denen der transparente Kontakt die Rolle des Metallkontaktes übernimmt und zur Extraktion von Elektronen dient. Der transparente Kontakt wird dann im reemissiven Betrieb positiv gegenüber dem Metallkontakt gepolt, ohne daß eine Ladungsträgerinjektion stattfindet. Grundsätzlich wäre zu erwarten, dass bei einem positiv gepolten transparenten Kontakt und einem negativ gepolten Metallkontakt lediglich der emissive Betrieb (Elektrolumineszenz) und nicht der reemissive Betrieb (Unterdrückung der Photolumineszenz) möglich ist, weil üblicherweise Lochinjektion aus dem transparenten Kontakt erfolgt. Überraschender Weise wurde jedoch gefunden, dass der reemissive Betrieb auch mit einer invertierten Schichtstruktur möglich ist, bei welcher die Löcherblockierschicht Zinnoxid, Titanoxid, Zirkonoxid, Hafniumoxid, Tantaloxid, Zinksulfid und/oder Zinkoxid und Metallkontakt (Kathode) Gold, Palladium, Platin, transparent leitfähige Oxide wie Indium-Zinnoxid oder Indium-Zinkoxid und/oder Nickel umfasst.

Weiterhin muß ein ausreichender energetischer Abstand zwischen HOMO und LUMO (sog. Bandlücke) gewährleistet sein. Um die Barrieren für Ladungsinjektion in Rückwärtsrichtung zu maximieren, muß die Bandlücke sowohl für Elektronenblockierschicht ausreichend als auch für Löcherblockierschicht groß sein. Die entsprechenden Materialien sollten deshalb im sichtbaren Spektralbereich kein Licht absorbieren.

Analog zum Photolumineszenzanzeigeelement (PQD) wird ein Display vorgeschlagen.

Die Erfindung wird nachstehend anhand eines Ausführungsbeispiels näher erläutert. Es zeigen:
- Figur 1:: ein erfindungsgemäßes Display mit Elektronenblockier- schicht und Löcherblockierschicht in schematischer Schnittdarstellung,
- Figur 2:: die energetischen Zustände von Valenzband und Leitungsband der Elektronenblockierschicht, der Emit- terschicht und der Löcherblockierschicht in schema- tischer Darstellung für ein Display, welches sowohl im emissiven als auch im reemissiven Betrieb schalt- bar ist,
- Figur 3:: die energetischen Zustände von Valenzband und Leitungsband der Elektronenblockierschicht, der Emit- terschicht und der Löcherblockierschicht in schemati- scher Darstellung für ein Display, welches im reemis- siven Betrieb schaltbar ist und
- Figur 4:: ein erfindungsgemäßes Display mit invertierter Schichtstruktur mit einer Löcherblockierschicht auf anorganischer Basis in schematischer Schnittdarstellung und
- Figur 5:: die energetischen Zustände von Valenzband und Leitungsband der Emitterschicht und der Löcherblockierschicht in schematischer Darstellung für ein Display mit invertierter Schichtstruktur nach Fig. 4, welches im reemissiven Betrieb schaltbar ist.

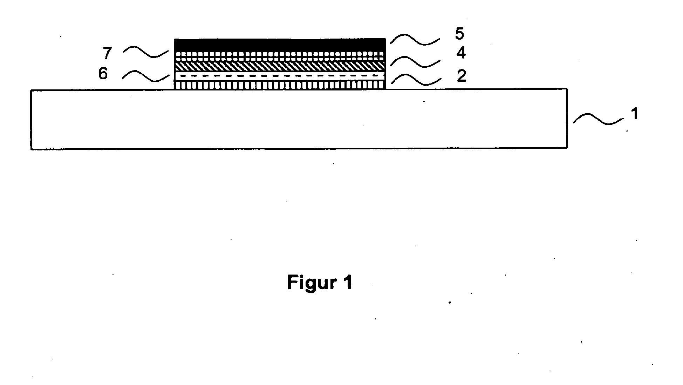

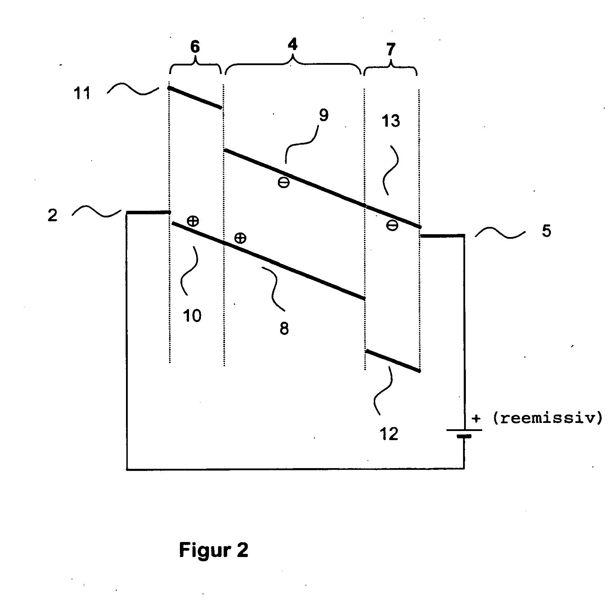

Figur 1 zeigt ein erfindungsgemäßes Display in schematischer Schnittdarstellung. Auf einem Glassubstrat 1 wird ein transparenter Kontakt 2 angeordnet. Dieser transparente Kontakt 2 bildet (im reemissiven Betrieb) die Kathode des Displays aus. Auf der Schicht des transparenten Kontaktes 2 ist eine Elektronenblockierschicht 6 angeordnet. Auf der Elektronenblockierschicht 6 wird die organische Emitterschicht 4 und darauf eine Löcherblockierschicht 7 angeordnet. Den Abschluss bildet die Schicht 5 (Anode im reemissiven Betrieb) eines Metallkontaktes mit niedriger Austrittsarbeit. Zur Reduzierung des Dunkelstroms des Displays in Rückwärtsrichtung (während des reemissiven Betriebs), sind die Materialien der Emitterschicht 4, der Elektronenblockierschicht 6 und der Löcherblockierschicht 7 derart gewählt, dass sich die Energieniveaus von Valenzband und Leitungsband der entsprechenden Schichten 4, 6 und 7 entsprechend Figur 2 verhalten.

Die Materialien der Elektronenblockierschicht 6, der Löcherblockierschicht 7 und der Emitterschicht 4 sind so gewählt, dass das Leitungsband 9 (niedrigstes unbesetztes Molekülorbital) der Emitterschicht 4 dem Leitungsband 13 der Löcherblockierschicht 7 und das Valenzband 8 (höchstes besetztes Molekülorbital) der Emitterschicht 4 dem Valenzband 10 der Elektronenblockierschicht 6 entspricht und weiterhin das Leitungsband 11 der Elektronenblockierschicht 6 energetisch höher ist als das Leitungsband 9 der Emitterschicht 4 und das Valenzband 8 der Emitterschicht 4 energetisch höher ist als das Valenzband 12 der Löcherblockierschicht 7. Durch diese Anpassung wird es möglich, dass in der Emitterschicht 4 erzeugte Ladungsträger ohne Barrieren abfließen können. Hierdurch wird sowohl ein emissiver als auch ein reemissiver Betrieb des Displays ermöglicht.

Als Materialien für Elektronenblockierschicht 6 und Löcherblockierschicht 7 können organische Materialien mit Pi-konjugierten Elektronensystemen verwendet werden, bei denen die Lage der entsprechenden Energieniveaus durch die Auswahl der Molekülstruktur bestimmt wird. Geeignete Materialklassen für die Elektronenblockierschicht 6 sind unter anderem Derivate von Triphenylamin, Benzidin und Phenylendiamin. Geeignete Materialklassen für die Löcherblockierschicht 7 umfassen Oxadiazole, Oxazole, Triazole, Chinoxaline sowie Derivate von Napthalincarbonsäureimid, Perylendicarbon-säurediimid und/oder Napthalindicarbon-säurediimid. Die Materialien können sowohl niedermolekular sein als auch polymerer Natur. Der Umfang der Erfindung ist jedoch nicht auf diese Materialien begrenzt.

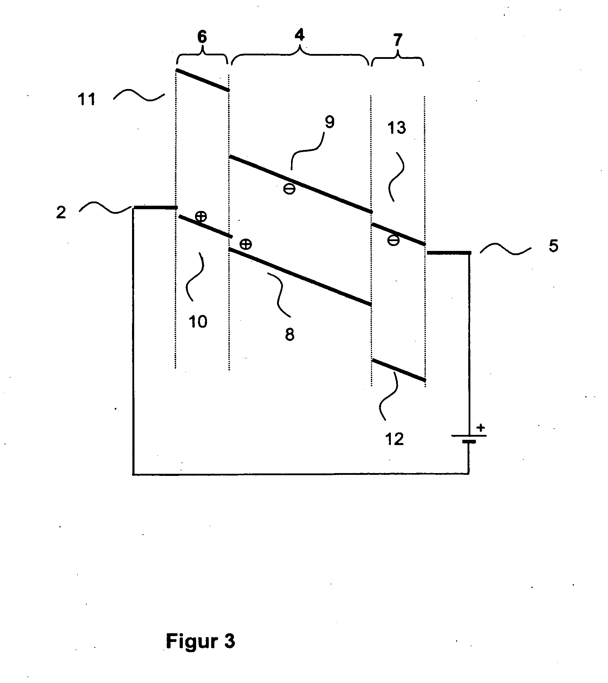

Wird das Display lediglich in einer Applikation für den reemissiven Betrieb benötigt (Elektrode 2 bildet Kathode, Elektrode 5 bildet Anode), kann es erfindungsgemäß auch vorgesehen sein, dass das Leitungsband 9 der Emitterschicht energetisch höher als das Leitungsband 13 der Löcherblockierschicht 7 und das Valenzband 10 der Elektronenblockierschicht 6 energetisch höher als das Valenzband 8 der Emitterschicht 4 ausgebildet ist, wie in Fig. 3 schematisch dargestellt ist. In diesem Fall ist kein (emissiver) Vorwärtsbetrieb aufgrund der entstandenen Barrieren möglich. In diesem Ausführungsbeispiel ist die Auswahl der Materialien für die Schicht des Metallkontaktes 5 nicht auf unedle Metalle begrenzt, so dass auch Materialien mit verbesserter Korrosionsbeständigkeit, wie Ag, Au, Pd, Pt oder Ni, verwendet werden können, was zu einer besseren Korrosionsbeständigkeit führt.

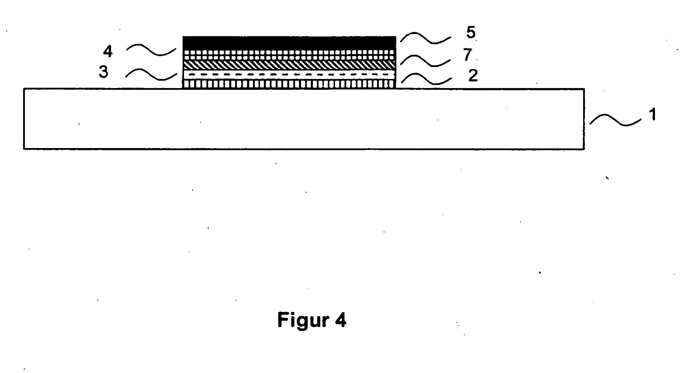

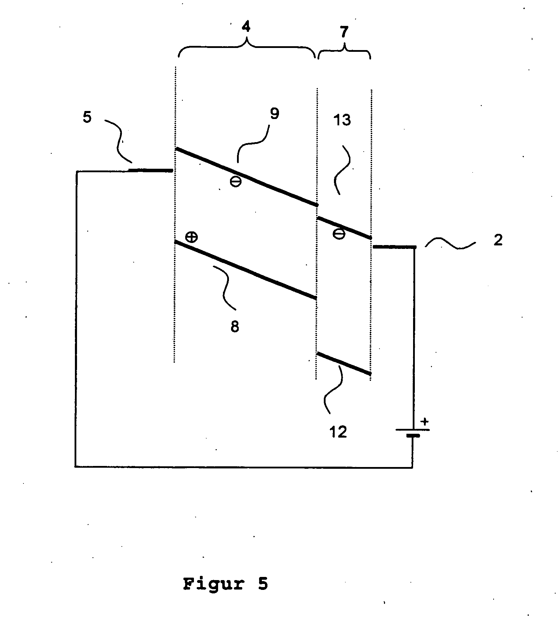

Dadurch, dass das Leitungsband 9 der Emitterschicht energetisch höher als das Leitungsband 13 der Löcherblockierschicht 7 ist, wird es weiterhin möglich, invertierte Schichtstrukturen, wie in Fig.4 gezeigt, herzustellen, bei denen der transparente Kontakt die Rolle des Metallkontaktes übernimmt und zur Extraktion von Elektronen dient. Der transparente Kontakt 2 wird dann, wie in Fig. 5 gezeigt, im reemissiven Betrieb positiv gegenüber dem Metallkontakt 5 gepolt, ohne dass eine Ladungsträgerinjektion stattfindet.

Die gezeigte Struktur benötigt keine Elektronenblockierschicht. Stattdessen wird durch geeignete Wahl des Metallkontaktes 5 sichergestellt, dass allein durch die hohe Austrittsarbeit des Metalls keine Injektion von Elektronen stattfindet. Die Injektion von Löchern aus dem transparenten Kontakt 2 wird durch die Löchersperrschicht 7 verhindert. Dazu muss die Energielage des Leitungsbandes der Sperrschicht 7 möglichst niedrig liegen. Dies wird durch die Wahl anorganischer Halbleiter mit grosser Bandlücke wie SnO₂, TiO2, ZnO, Ta₂O₅, ZrO₂, HfO₂ und ZnS erreicht.

Das in Figur 4 gezeigte Display mit invertierter Schichtstruktur, welches lediglich für den reemissiven Betrieb vorgesehen ist, (entsprechendes Energieniveauschema ist in Figur 5 dargestellt) kann in einer bevorzugten Ausführungsvariante wie folgt hergestellt werden:

Ausgehend von einem mit Indium-Zinnoxid (Schicht des transparenten Kontakts 2) beschichteten Glassubstrat 1 wird die Lochtransportschicht 3 mittels Aufschleudern von Poly(ethylendioxythiophen)/Polystyrolsulfonsäure mit einer Dicke im Bereich von 30-100 nm aufgebracht. Nachfolgend wird als Löcherblockierschicht 7 durch reaktives Aufdampfen im Vakuum eine Schicht von Zinnoxid SnO₂ oder von Titandioxid TiO₂ mit einer Dicke im Bereich von 10-80 nm aufgebracht. Dazu wird Zinnoxid thermisch verdampft bzw. Titandioxyd elektronenstrahlverdampft unter einem Sauerstoffpartialdruck im Bereich von 10⁻⁴ bis 10⁻³ mBar. Die Emitterschicht 4 besteht aus einem Derivat von Poly(phenylenvinylen) bzw. Poly(alkylfluoren) und wird mittels Aufschleudern aus einem organischen Lösungsmittel in einer Dicke von 30 bis 120 nm aufgebracht. Als Schicht eines Metallkontakts 5 wird eine Goldschicht mit einer Dicke von 20-100 Nanometern im Hochvakuum aufgedampft, wobei die Schicht 5 eine hohe Austrittsarbeit besitzt. Die Struktur wird vervollständigt durch eine (hier nicht dargestellte) wasser- und gasdichte Verkapselung.

Die Erfindung beschränkt sich nicht auf die hier dargestellten Ausführungsbeispiele. Vielmehr ist es möglich, durch Kombination und Modifikation der genannten Mittel und Merkmale weitere Ausführungsvarianten zu realisieren, ohne den Rahmen der Erfindung zu verlassen.

### Bezugszeichenliste

- 1: Glassubstrat
- 2: Schicht eines transparenten Kontaktes
- 3: Lochtransportschicht
- 4: Emitterschicht
- 5: Schicht eines Metallkontaktes
- 6: Elektronenblockierschicht
- 7: Löcherblockierschicht
- 8: Valenzband der Emitterschicht (höchstes besetztes Molekülorbital)
- 9: Leitungsband der Emitterschicht (niedrig besetztes Molekülorbital)
- 10: Valenzband der Elektronenblockierschicht höchstes besetztes Molekülorbital)
- 11: Leitungsband der Elektronenblockierschicht (niedrig besetztes Molekülorbital)
- 12: Valenzband der Löcherblockierschicht (höchstes besetztes Molekülorbital)
- 13: Leitungsband der Löcherblockierschicht (niedrig besetztes Molekülorbital)

## Patentansprüche

1. Photolumineszenzanzeigeelement, PQD, umfassend eine erste Elektrode (2), welche lichtdurchlässig und auf der Frontseite eines organischen, lichtemittiereden Materials (4) angeordnet ist, und eine zweite Elektrode (5), welche auf der Rückseite des organischen, lichtemittiereden Materials (4) angeordnet ist,
**dadurch gekennzeichnet, dass**
das Photolumineszenzanzeigeelement eine Löcherblockierschicht (7) aufweist, welche zwischen dem organischen, lichtemittierenden Material (4) und der ersten Elektrode (2) angeordnet ist und
das höchste besetzte Molekülorbital (12) der Löcherblockierschicht (7) energetisch niedriger als das höchste besetzte Molekülorbital (8) des organischen, lichtemittierenden Materials (4) ist und
die Löcherblockierschicht (7) Zirkonoxid, Hafniumoxid, Zinksulfid, Zinnoxid, Tantaloxid, Titanoxid und/oder Zinkoxid und die zweite Elektrode (5) Gold, Palladium, Platin, ein transparentes, leitfähiges Oxid und/oder Nickel umfasst.

2. PQD nach Anspruch 1, **dadurch gekennzeichnet, dass** das niedrigste unbesetzte Molekülorbital (9) des lichtemittierenden Materials (4) dem niedrigsten unbesetzten Molekülorbital (13) der Löcherblockierschicht (7) entspricht.

3. PQD nach Anspruch 1, **dadurch gekennzeichnet, dass** das niedrigste unbesetzte Molekülorbital (9) des lichtemittierenden Materials (4) energetisch höher als das niedrigste unbesetzte Molekülorbital (13) der Löcherblockierschicht (7) ist.

4. PQD nach einem der vorhergehenden Ansprüche, **dadurch gekennzeichnet, dass** das PQD eine Elektronenblockierschicht aufweist, wobei das niedrigste unbesetzte Molekülorbital der Elektronenblockierschicht energetisch höher als das niedrigste unbesetzte Molekülorbital des organischen, lichtemittierenden Materials ist.

5. PQD nach Anspruch 4 **dadurch gekennzeichnet, dass** der energetische Abstand zwischen dem höchsten besetzten Molekülorbital (10) der Elektronenblockierschicht (6) und niedrigsten unbesetzten Molekülorbital der Elektronenblockierschicht (6) und der energetische Abstand zwischen dem höchsten besetzten Molekülorbital der Löcherblockierschicht (7) und niedrigsten unbesetzten Molekülorbital der Löcherblockierschicht (7) mindestens 3 eV beträgt.

6. PQD nach Anspruch 4, **dadurch gekennzeichnet, dass** die Elektronenblockierschicht (6) mindestens ein Derivat von Triphenylamin, Benzidin und/oder Phenylendiamin aufweist und die Löcherblockierschicht mindestens eine Verbindung der Materialklassen der Oxadiazole, Oxazole, Triazole, Chinoxaline und/oder mindestens ein Derivat von Napthalincarbonsäureimid, Perylendicarbon-säurediimid und/oder Napthalindicarbon-säurediimid und Zirkonoxid, Hafniumoxid, Zinksulfid, Zinnoxid, Titanoxid und/oder Zinkoxid aufweist.

7. PQD nach einem der vorhergehenden. Ansprüche, **dadurch gekennzeichnet, dass** das transparente, leitfähige Oxid Indium-Zinnoxid oder Indium-Zinkoxid ist.

8. Display umfassend eine Substrat (1) mit mindestens einem Photolumineszenzanzeigeelement nach einem der vorhergehenden Ansprüche.

## Claims

1. Photoluminescent display element, PQD, comprising a first electrode (2), which is light-transmitting and arranged on the front side of an organic, light-emitting material (4), and a second electrode (5), which is arranged on the rear side of the organic, light-emitting material (4),
**characterised in that**
the photoluminescent display element has a hole-blocking layer (7), which is arranged between the organic, light-emitting material (4) and the first electrode (2), and
the highest occupied molecular orbital (12) of the hole-blocking layer (7) is of lower energy than the highest occupied molecular orbital (8) of the organic, light-emitting material (4), and
the hole-blocking layer (7) comprises zirconium oxide, hafnium oxide, zinc sulphide, tin oxide, tantalum oxide, titanium oxide and/or zinc oxide and the second electrode (5) comprises gold, palladium, platinum, a transparent, conductive oxide and/or nickel.

2. PQD according to Claim 1, **characterised in that** the lowest unoccupied molecular orbital (9) of the light-emitting material (4) corresponds to the lowest unoccupied molecular orbital (13) of the hole-blocking layer (7).

3. PQD according to Claim 1, **characterised in that** the lowest unoccupied molecular orbital (9) of the light-emitting material (4) is of higher energy than the lowest unoccupied molecular orbital (13) of the hole-blocking layer (7).

4. PQD according to one of the preceding claims, **characterised in that** the PQD has an electron-blocking layer, the lowest unoccupied molecular orbital of the electron-blocking layer being of higher energy than the lowest unoccupied molecular orbital of the organic, light-emitting material.

5. PQD according to Claim 4, **characterised in that** the energy gap between the highest occupied molecular orbital (10) of the electron-blocking layer (6) and the lowest unoccupied molecular orbital of the electron-blocking layer (6) and the energy gap between the highest occupied molecular orbital of the hole-blocking layer (7) and the lowest unoccupied molecular orbital of the hole-blocking layer (7) is at least 3 eV.

6. POD according to Claim 4, **characterised in that** the electron-blocking layer (6) has at least one derivative of triphenylamine, benzidine and/or phenylenediamine and the hole-blocking layer has at least one compound of the material classes of the oxadiazoles, oxazoles, triazoles, quinoxalines and/or at least one derivative of naphthalene carboxylic acid imide, perylene dicarboxylic acid diimide and/or naphthalene dicarboxylic acid diimide and zirconium oxide, hafnium oxide, zinc sulphide, tin oxide, titanium oxide and/or zinc oxide.

7. PQD according to one of the preceding claims, **characterised in that** the transparent, conductive oxide is indium tin oxide or indium zinc oxide.

8. Display comprising a substrate (1) having at least one photoluminescent display element according to one of the preceding claims.

## Revendications

1. Elément d'affichage à photoluminescence PQD, comprenant une première électrode (2), qui est transparente et disposée sur le côté avant d'un matériau (4) organique électroluminescent, et une seconde électrode (5), qui est disposée sur le côté arrière du matériau (4) organique électroluminescent,
**caractérisé en ce que**
l'élément d'affichage à photoluminescence présente une couche de blocage de trous (7), qui est disposée entre le matériau (4) organique électroluminescent et la première électrode (2) et
l'orbitale moléculaire (12) occupée la plus haute de la couche de blocage de trous (7) est plus faible au plan énergétique que l'orbitale moléculaire (8) occupée la plus haute du matériau (4) organique électroluminescent et
la couche de blocage de trous (7) comprend de l'oxyde de zirconium, de l'oxyde d'hafnium, du sulfure de zinc, de l'oxyde d'étain, de l'oxyde de tantale, de l'oxyde de titane et/ou de l'oxyde de zinc et la seconde électrode (5) de l'or, du palladium, du platine, un oxyde transparent et conducteur et/ou du nickel.

2. PQD selon la revendication 1, **caractérisé en ce que** l'orbitale moléculaire (9) non occupée la plus basse du matériau (4) électroluminescent correspond à l'orbitale moléculaire (13) non occupée la plus basse de la couche de blocage de trous (7).

3. PQD selon la revendication 1, **caractérisé en ce que** l'orbitale moléculaire (9) non occupée la plus basse du matériau (4) électroluminescent est plus élevée au plan énergétique que l'orbitale moléculaire (13) non occupée la plus basse de la couche de blocage de trous (7).

4. PQD selon l'une quelconque des revendications précédentes, **caractérisé en ce que** le PQD présente une couche de blocage d'électrons, l'orbitale moléculaire non occupée fa plus basse de la couche de blocage d'électrons étant plus élevée au plan énergétique que l'orbitale moléculaire non occupée la plus basse du matériau organique électroluminescent.

5. PQD selon la revendication 4, **caractérisé en ce que** l'espacement énergétique entre "orbitale moléculaire (10) occupée la plus haute de la couche de blocage d'électrons (6) et l'orbitale moléculaire non occupée la plus basse de la couche de blocage d'électrons (6) et la distance énergétique entre l'orbitale moléculaire occupée la plus haute de la couche de blocage de trous (7) et l'orbitale moléculaire non occupée la plus basse de la couche de blocage de trous (7) sont d'au moins 3 eV.

6. PQD selon la revendication 4, **caractérisé en ce que** la couche de blocage d'électrons (6) présente au moins un dérivé de triphénylamine, de benzidine et/ou de phénylénediamine et la couche de blocage de trous présente au moins une combinaison des classes de matériau des oxadiazoles, oxazoles, triazoles, chinoxalines et/ou au moins un dérivé d'imide d'acide naphtaline-carboxylique, de diimide d'acide pérylène-dicarboxylique et/ou de diimide d'acide naphtaline-dicarboxylique et d'oxyde de zirconium, d'oxyde d'hafnium, de sulfure de zinc, d'oxyde d'étain, d'oxyde de titane et/ou d'oxyde de zinc.

7. PQD selon l'une quelconque des revendications précédentes, **caractérisé en ce que** l'oxyde transparent et conducteur est de l'oxyde d'étain-indium ou de l'oxyde de zincindium.

8. Ecran de visualisation comprenant un substrat (1) avec au moins un élément d`affichage à luminescence selon l'une quelconque des revendications précédentes.
